# EUROPEAN PATENT SPECIFICATION

(11) **EP 3 486 959 B1**
(45) Date of publication and mention of the grant of the patent: **15.07.2026**
(21) Application number: 18210432.3
(22) Date of filing: 13.04.2016
(51) Int. Cl.: H10H 20/851, F21V 7/05, F21K 9/64

(54) **PHOSPHOR DEVICE**
PHOSPHORVORRICHTUNG
DISPOSITIF DE PHOSPHORE

(30) Priority: 22.12.2015 TW 104143205
(43) Date of publication of application: 22.05.2019
(62) Divisional of application: 16165131.0
(73) Proprietor: Delta Electronics, Inc., Taoyuan City 333 (TW)
(72) Inventor: Chang, Keh-Su, 33370 Taoyuan City (TW); Chou, Yen-I, 33370 Taoyuan City (TW); Chen, Chi, 33370 Taoyuan City (TW)
(74) Representative: 2K Patent Partnerschaft mbB

(56) References cited:
- EP-A2- 2 362 452
- WO-A2-2012/135744
- US-A1- 2009 224 177
- US-A1- 2011 156 071
- US-A1- 2014 334 181
- CHANG-YU SHEN ET AL: "White LED Based on YAG : Ce,Gd Phosphor and CdSe-ZnS Core/Shell Quantum Dots", IEEE PHOTONICS TECHNOLOGY LETTERS, IEEE, USA, vol. 22, no. 12, 15 June 2010 (2010-06-15), pages 884 - 886, XP011306817, ISSN: 1041-1135

## Description

### FIELD OF THE INVENTION

The present invention relates to a phosphor device, and more particularly to a phosphor device.

### BACKGROUND OF THE INVENTION

In recent years, a variety of projectors have been widely used in various video applications. For example, projectors can be used for making presentations, holding meetings or giving lectures in classrooms, boardrooms, conference rooms or home theaters. By the projector, an image signal from an image signal source can be enlarged and shown on a display screen. For reducing power consumption and overall volume, the illumination system of the current projector employs a solid-state light-emitting element (e.g. light emitting diode or laser diode) to replace the conventional high intensity discharge (HID) lamp.

Generally, the illumination system of the projector may emit three primary color lights, i.e. a red light (R), a green light (G) and a blue light (B). Among three primary color solid-state light-emitting elements including a red solid-state light-emitting element, a green solid-state light-emitting element and a blue solid-state light-emitting element, the blue solid-state light-emitting element has the highest luminous efficiency. Since the red solid-state light-emitting element and the green solid-state light-emitting element have poor luminous efficiency, the red light or the green light may be produced by using a blue solid-state light-emitting element and a wavelength conversion device (e.g. a phosphor wheel). That is, the uses of the blue solid-state light-emitting element and the phosphor wheel may directly emit the red light or the green light in replace of the red solid-state light-emitting element or the green solid-state light-emitting element. Consequently, the luminous efficiency of the whole illumination system is enhanced and the manufacturing cost of the illumination system is reduced.

However, it still has some drawbacks of using a solid-state light-emitting element to emit an excitation light and a phosphor wheel to convert the wavelength of the excitation light. When using a solid-state light-emitting element and a phosphor wheel coated with a phosphor agent to emit an excitation light to be separated as color lights for projecting, the luminous intensity or the saturation level of a color light may be not enough.

US 2011/156071 A1 discloses a multi-stack package light emitting diode (LED) including an LED chip, a first fluorescent powder layer, a first optical bandpass filter layer and a second fluorescent powder layer. The LED chip generates an LED light. The first fluorescent powder layer and the second fluorescent powder layer respectively have a first fluorescent powder and a second fluorescent powder. The first fluorescent powder and the second fluorescent powder are excited by the LED light to respectively generate a first excitation light and a second excitation light. The first optical bandpass filter layer allows the LED light and the first excitation light to pass and reflects the second excitation light. A wavelength of the LED light is shorter than a wavelength of the second excitation light. The wavelength of the second excitation light is shorter than a wavelength of the first excitation light. Therefore, the multi-stack package LED improves a light emission efficiency.

WO 2012135744 A2 discloses a light-emitting device including a light source, a first light-emitting material spaced apart from the light source, and at least one additional light-emitting material. The first light-emitting material includes low reabsorbing semiconductor nanocrystals having an emission-center core, an exterior protective shell, and at least one inner light-absorbing shell. The device is useful for efficiently producing white light having a high color rendering index.

The article "White LED Based on YAG: Ce, Gd, Phosphor and CdSe-ZnS Core/Shell Quantum Dots" by Chang-yu Shen et al., published on June 15, 2010 in IEEE Photonics Technology Letters, Vol. 22, No. 12 relates to a study wherein Core/shell CdSe-ZnS quantum dots (QDs) with a peak emission wavelength of 618 nm and size of ~ 5.5 nm were synthesized by thermal deposition approach. High photoluminescence efficiency with a quantum yield of more than 48% has been achieved. Red-shift of a peak emission wavelength from 532 to 568 nm was realized by doping Gd 3+ ions into the YAG : Ce 3+ to substitute some Y 3+ ions. To compensate the poor color rendering index (CRI) of the YAG : Ce-based white light-emitting diode (LED) due to the lack of red spectral component, CdSe-ZnS QDs were blended into YAG : Ce 3+ , Gd 3+ phosphors. Prominent spectral evolution has been achieved by increasing the content of QDs. White LED combining a blue LED with the blends of phosphor and QDs with a weight ratio of 1:1, has been demonstrated with an improved CRI value of 90.

However, there is a need of providing an improved illumination system and an improved projection apparatus in order to eliminate the above drawbacks.

### SUMMARY OF THE INVENTION

It is an object of the present invention to provide a phosphor device for overcoming at least one of the above-mentioned drawbacks encountered by the prior arts.

The present invention provides a phosphor device and a manufacturing method thereof. By utilizing a phosphor layer including a first phosphor agent and a second phosphor agent, the luminous intensity of a color light, which is included in a second waveband light converted by the first phosphor agent, can be increased through the conversion of the second phosphor agent.

The present invention provides a phosphor device as defined by claim 1. Since a second phosphor layer including a first phosphor agent and a second phosphor agent is formed behind a first phosphor layer includes only the first phosphor agent along an optical path, most of the energy of a first waveband light is decreased by the first phosphor agent of the first phosphor layer, such that the conversion efficiency of the second phosphor agent is enhanced.

In accordance with claim 1, there is provided a phosphor device of an illumination system emitting a first waveband light to the phosphor device so as to be converted into a second waveband light. The phosphor device includes a substrate and a phosphor layer formed on the substrate. The phosphor device also includes a reflective coating disposed between the substrate and the phosphor layer for reflecting at least the second waveband light. The phosphor layer includes: a first phosphor agent, wherein the first waveband light is converted into a waveband light with peak value corresponded to yellow light comprising a first light with wavelength less than or equal to 590 nm and a second light with wavelength greater than 590 nm by the first phosphor agent. The invention is characterized in that the phosphor layer further includes a second phosphor agent, distributed over the first phosphor agent of the phosphor layer for converting the first waveband light into a third light, wherein the range of the spectrum of the second light and the range of the spectrum of the third light are at least partially overlapped so as to increase the intensity of the second light, and the first light, the second light and the third light are integrated as the second waveband light. The second phosphor agent is mixed with the first phosphor agent as a mixture, and wherein the weight percentage of the second phosphor agent is less than 85% relative to the first phosphor agent.

The above contents of the present invention will become more readily apparent to those ordinarily skilled in the art after reviewing the following detailed description and accompanying drawings, in which:

### BRIEF DESCRIPTION OF THE DRAWINGS

FIG. 1A schematically illustrates a phosphor device including a reflective substrate and an illumination system including the phosphor device according to an embodiment, not defining *per se* the present invention as claimed but useful for understanding its context;
FIG. 1B schematically illustrates the structure of the phosphor device as shown in FIG. 1A;
FIG. 2A schematically illustrates a phosphor device including a transmissive substrate and an illumination system including the phosphor device according to an embodiment, not defining *per se* the present invention as claimed but useful for understanding its context;
FIG. 2B schematically illustrates the structure of the phosphor device as shown in FIG. 2A;
FIG. 3 schematically illustrates the structure of a phosphor device including a reflective substrate according to an embodiment, not defining *per se* the present invention as claimed but useful for understanding its context;
FIG. 4 schematically illustrates the structure of a phosphor device including a transmissive substrate according to an embodiment forming part of the present invention;
FIG. 5 schematically illustrates an intensity-wavelength diagram of visible lights of a phosphor device including a yellow phosphor agent and a red phosphor agent of the present invention, and a phosphor device utilizing a yellow phosphor agent and a phosphor device utilizing a red phosphor agent of prior art;
FIG. 6A schematically illustrates a phosphor device including a reflective substrate and an illumination system including the phosphor device according to an embodiment, not defining *per se* the present invention as claimed but useful for understanding its context;
FIG. 6B schematically illustrates the structure of the phosphor device as shown in FIG. 6A;
FIG. 7A schematically illustrates a phosphor device including a transmissive substrate and an illumination system including the phosphor device according to an embodiment, not defining *per se* the present invention as claimed but useful for understanding its context; and
FIG. 7B schematically illustrates the structure of the phosphor device as shown in FIG. 7A.

### DETAILED DESCRIPTION OF THE PREFERRED EMBODIMENT

The present invention will now be described more specifically with reference to the following embodiments. It is to be noted that the following descriptions of preferred embodiments of this invention are presented herein for purpose of illustration and description only. It is not intended to be exhaustive or to be limited to the precise form disclosed.

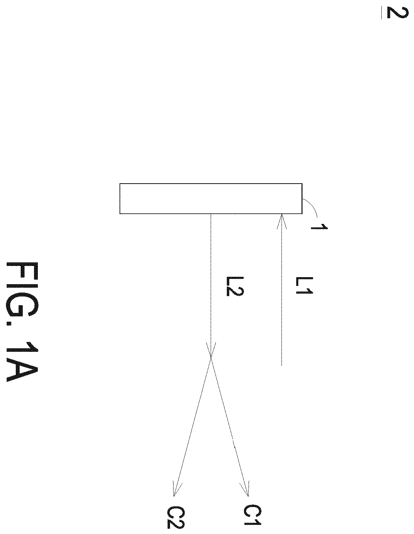

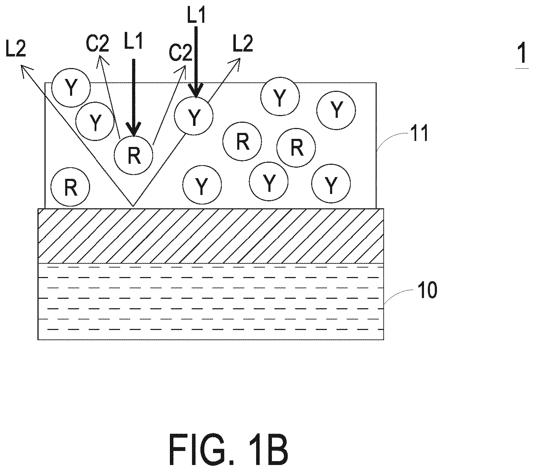

FIG. 1A schematically illustrates a phosphor device including a reflective substrate and an illumination system including the phosphor device according to an embodiment of the present invention. FIG. 1B schematically illustrates the structure of the phosphor device as shown in FIG. 1A. As shown in FIG. 1A and FIG. 1B, a phosphor device 1 of an illumination system 2, in which the illumination system 2 emits a first waveband light L1, includes a substrate 10 and a first phosphor layer 11. The first phosphor layer 11 includes a first phosphor agent Y and a second phosphor agent R. The first phosphor agent Y is formed on the substrate 10 for converting the first waveband light L1 into a second waveband light L2. The second waveband light L2, which could be separated by optical device for projecting, includes a first color light C1 and a second color light C2. The second phosphor agent R is distributed over the first phosphor agent Y for converting the first waveband light L1 into the second color light C2 so as to increase the luminous intensity of the second color light C2.

It should be noted that in a manufacturing method of the phosphor device 1, after the substrate 10 is provided, the first phosphor layer 11 including the first phosphor agent Y and the second phosphor agent R is formed on the substrate 10. The second phosphor agent R is utilized for converting the first waveband light L1 into enhancing the second color light C2, thereby increasing the luminous intensity of the second color light C2 outputted by the phosphor device 1. The second phosphor agent R can be added in the first phosphor layer 11 with an average distribution or a gradient distribution, such that the second phosphor agent R is distributed over the first phosphor agent Y. Certainly, the second phosphor agent R can be mixed with the first phosphor agent Y as a mixture in a mixing manner. Alternatively, the second phosphor agent R and the first phosphor agent Y can be formed as a plurality of segments. The segments are for example arranged on the first phosphor layer 11 with a pie-shaped distribution, but not limited thereto. The segment each includes the first phosphor agent Y or the second phosphor R, or every one of the segment includes the first phosphor agent Y and the second phosphor agent R simultaneously.

In this embodiment and the following embodiments, the first phosphor agent Y is for example a yellow phosphor agent, but not limited thereto. Meanwhile, the second phosphor agent R is for example a red phosphor agent, but not limited thereto. In some situations, the second phosphor agent R may be a green phosphor agent. The primary spirit of the second phosphor agent R is to enhance the intensity and adjust the color saturation level of at least one of the color lights included in the excitation light (the second waveband light L2), which is excited by the first phosphor agent Y. Furthermore, the symbols (letters) "Y" and "R" are illustrated for indicating the first phosphor agent and the second phosphor agent but not for limiting the colors of the first phosphor agent and the second phosphor agent.

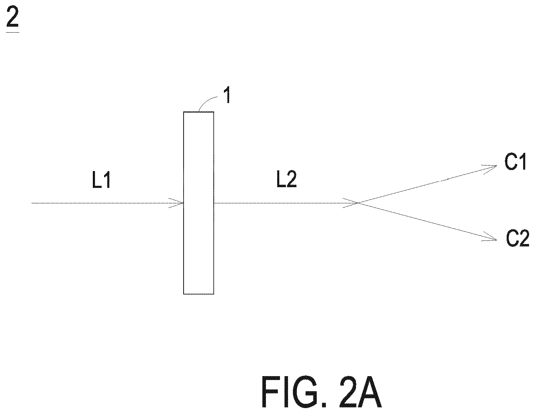

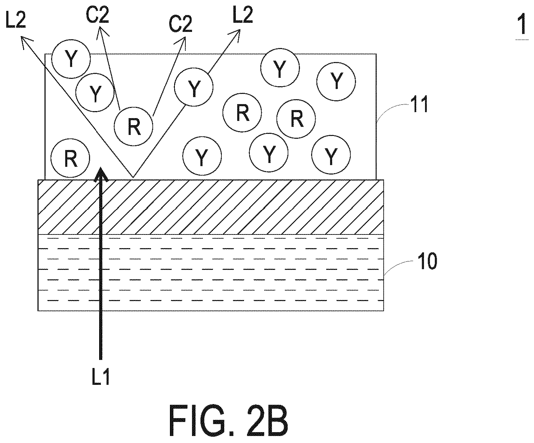

FIG. 2A schematically illustrates a phosphor device including a transmissive substrate and an illumination system including the phosphor device according to an embodiment, not defining *per se* the present invention as claimed but useful for understanding its context. FIG. 2B schematically illustrates the structure of the phosphor device as shown in FIG. 2A. As shown in FIG. 2A and FIG. 2B, a phosphor device 1 of an illumination system 2 includes a substrate 10 and a first phosphor layer 11. The first phosphor layer 11 is similar with the first phosphor layer 11 described in the previous embodiment, and is not redundantly described herein. In this embodiment, the substrate 10 is a transmissive substrate.

It should be noted that the phosphor device 1 of the present invention can be considered or realized in another way. In an embodiment, the first phosphor layer 11 is formed on the substrate and comprising a first ingredient and a second ingredient. The first ingredient can be the first phosphor agent, and so does the second ingredient. Furthermore, the first waveband light L1 is converted into a first color light C1 and a second color light C2 by the first ingredient. The second ingredient is distributed over the first ingredient for converting the first waveband light L1 into a third color light, in which the range of the spectrum of the second color light C2 and the range of the spectrum of the third color light are at least partially overlapped, and the first color light C1, the second color light C2 and the third color light are integrated as the second waveband light L2. Since the range of the spectrum of the second color light C2 and the range of the spectrum of the third color light are at least partially overlapped, at least a portion of the intensity of the second color light C2 is increased.

On the other hand, when the third color light converted by the second ingredient is similar with the second color light C2 converted by the first ingredient, the range of the spectrum of the second color light C2 and the range of the spectrum of the third color light are completely overlapped, and the phosphor device 1 meets the embodiments mentioned above. That is, the range of the spectrum of the color light converted by the second ingredient can be selected or adjusted to meet the practical demands but not limited by the embodiments of the present invention.

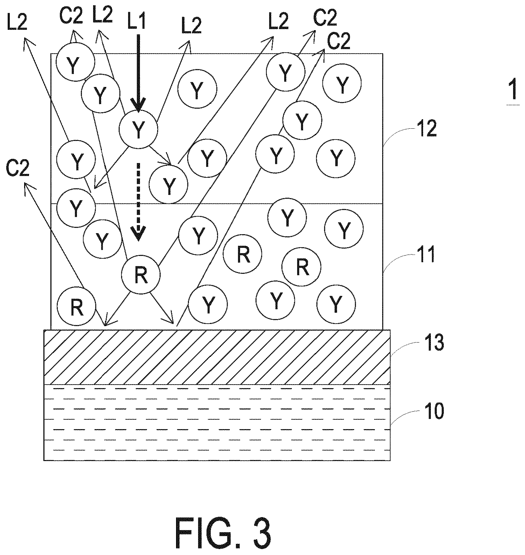

FIG. 3 schematically illustrates the structure of a phosphor device including a reflective substrate according to an embodiment not forming part of the present invention. As shown in FIG. 1B and FIG. 3, the phosphor device 1 further includes a second phosphor layer 12. In some embodiments, the substrate 10 is a reflective substrate, and the second phosphor layer 12 is disposed on the first phosphor layer 11. The second phosphor layer 12 includes the first phosphor agent Y for converting the first waveband light L1 into the second waveband light L2 and decreasing the energy of the first waveband light L1. That is, when the incident light (i.e. the first waveband light L1) is transmitted through the second phosphor layer 12, a large portion of energy of the incident light is converted. For example, the residue power of the first waveband light L1 inputted into the phosphor layer 11 is less than 40 watts, but not limited thereto.

The thickness of each of the first phosphor layer 11 and the second phosphor layer 12 is greater than or equal to 10 micrometers (i.e. ≥10 µm), and less than or equal to 500 micrometers (i.e. ≤500 µm). In preferred embodiments, the thickness of each of the first phosphor layer 11 and the second phosphor layer 12 is greater than or equal to 50 micrometers (i.e. ≥50 µm), and less than or equal to 200 micrometers (i.e. ≤200 µm). It should be noted that the thickness of the first phosphor layer 11 can be equal to or unequal to the thickness of the second phosphor layer 12. In addition, the weight percentage of the second phosphor agent R is less than 85% relative to the first phosphor agent Y.

In this embodiment, the phosphor device 1 further includes a reflective coating 13. The reflective coating 13 is disposed between the substrate 10 and the first phosphor layer 11 for reflecting at least the second waveband light L2. An example of the reflective coating 13 includes but not limited to an all reflective coating, or a dichroic coating. While utilizing a dichroic coating as the reflective coating 13, a color light having the similar range of wavelength with the second waveband light L2 can be reflected by the reflective coating 13. Certainly, the first color light C1 and the second color light C2 both can be reflected by the reflective coating 13. While utilizing a reflective coating, almost all of visible light is reflected by the reflective coating 13.

In a manufacturing method of the phosphor device 1 including a reflective substrate, after the reflective substrate is provided, the first phosphor layer 11 including the first phosphor agent Y and the second phosphor agent R is formed on the reflective substrate. The second phosphor agent R is utilized for converting the first waveband light L1 into the third color light as described above, thereby increasing the luminous intensity of the second color light C2 outputted by the phosphor device 1. Next, the second phosphor layer 12 is formed on the first phosphor layer 11. The second phosphor layer 12 includes the first phosphor agent Y for converting the first waveband light L1 into the second waveband light L2 and decreasing the energy of the first waveband light L1. Moreover, the reflective coating 13 can be pre-coated on the substrate 10, or be formed on the substrate while processing the manufacturing method.

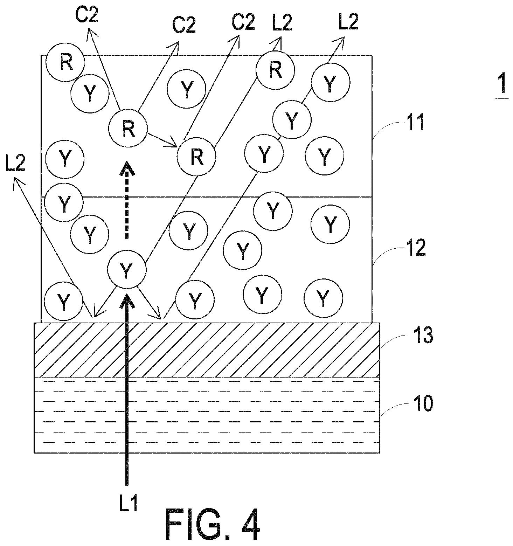

Please refer to FIG. 2B and FIG. 4. FIG. 4 schematically illustrates the structure of a phosphor device including a transmissive substrate according to an embodiment forming part of the present invention. In this embodiment, the phosphor device 1 further includes a second phosphor layer 12. The substrate 10 is a transmissive substrate, and the second phosphor layer 12 is disposed between the first phosphor layer 11 and the substrate 10. The second phosphor layer 12 includes the first phosphor agent Y for converting the first waveband light L1 into the second waveband light L2 and decreasing the energy of the first waveband light L1 simultaneously. That is, when the incident light (i.e. the first waveband light L1) is transmitted through the second phosphor layer 12, a large portion of energy of the incident light is converted. For example, the residue power of the first waveband light L1 inputted into the phosphor layer 11 is less than 40 watts, but not limited thereto.

The thickness of each of the first phosphor layer 11 and the second phosphor layer 12 is greater than or equal to 10 micrometers, and less than or equal to 500 micrometers. In preferred embodiments, the thickness of each of the first phosphor layer 11 and the second phosphor layer 12 is greater than or equal to 50 micrometers, and less than or equal to 200 micrometers. The weight percentage of the second phosphor agent R is less than 85% relative to the first phosphor agent Y.

In the present invention, the phosphor device 1 further includes a reflective coating 13. The reflective coating 13 is disposed between the substrate 10 and the second phosphor layer 12 for reflecting the second waveband light L2. An example of the reflective coating 13 includes but not limited to a dichroic coating. While utilizing a dichroic coating as the reflective coating 13, a color light having the similar range of wavelength with the first waveband light L1 can be passed through the reflective coating 13, and a color light having the similar range of wavelength with the second waveband light L2 can be reflected by the reflective coating 13.

In a manufacturing method of the phosphor device 1 including a transmissive substrate, after the transmissive substrate is provided, the second phosphor layer 12 including the first phosphor agent Y is formed on the transmissive substrate. The first phosphor layer 11 is then formed on the second phosphor layer 12. The first phosphor layer 11 includes the first phosphor agent Y for converting the first waveband light L1 into the second waveband light L2, and the second waveband light L2 comprises a first color light C1 and a second color light C2. Next, the second phosphor agent R is added in the first phosphor layer 11 for converting the first waveband light L1 into the second color light C2, thereby increasing the luminous intensity of the second color light C2 outputted by the phosphor device 1. Moreover, the reflective coating 13 can be pre-coated on the substrate 10, or be formed on the substrate while processing the manufacturing method.

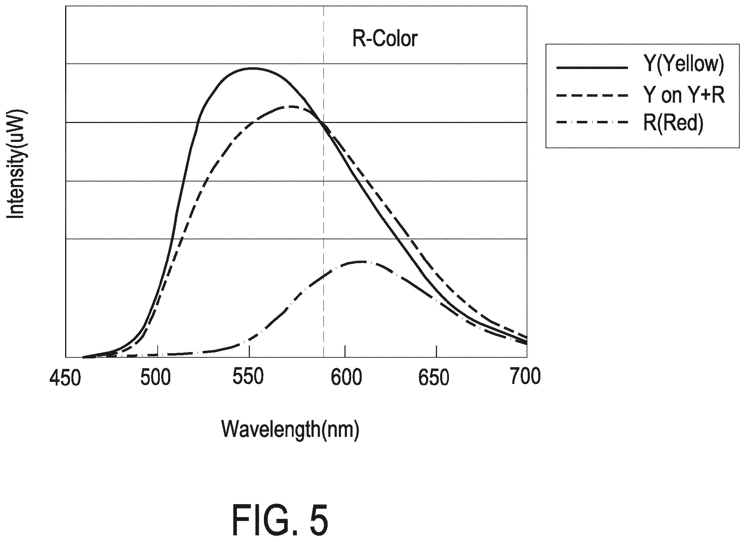

Please refer to FIG. 1, FIG. 3 and FIG. 5. FIG. 5 schematically illustrates an intensity-wavelength diagram of visible lights of a phosphor device including a yellow phosphor agent as the second phosphor layer 12, and a yellow phosphor agent mixed with a red phosphor agent as the second phosphor layer 11 of the present invention. It is the comparison with a phosphor device utilizing a yellow phosphor agent and a phosphor device utilizing a red phosphor agent of prior art. FIG. 5 indicates that the intensities of red light (in the R-Color region) of the phosphor device 1 of the present invention shown in FIG. 3 (i.e. the curve Y on Y+R), a phosphor device utilizing a yellow phosphor agent of prior art (i.e. the curve Y) and a phosphor device utilizing a red phosphor agent of prior art (i.e. the curve R). Obviously, the intensity of red light of the phosphor device 1 of the present invention is greater the one of prior art. Furthermore, the following Table I illustrates a comparison data. The weight percentage of the second phosphor agent R is 25% relative to the first phosphor agent Y. The intensity of red light of the phosphor device utilizing a yellow phosphor agent of prior art is assumed as 100% for being the base of the comparison.

**Table I**

| L1 Power (Watts) | Intensity of red light (Y) | Intensity of red light (Y on Y+25wt%R) |
|---|---|---|
| 25 | 100.0% | 121.5% |
| 76 | 100.0% | 116.7% |
| 102 | 100.0% | 116.0% |
| 152 | 100.0% | 111.9% |
| 170 | 100.0% | 110.5% |

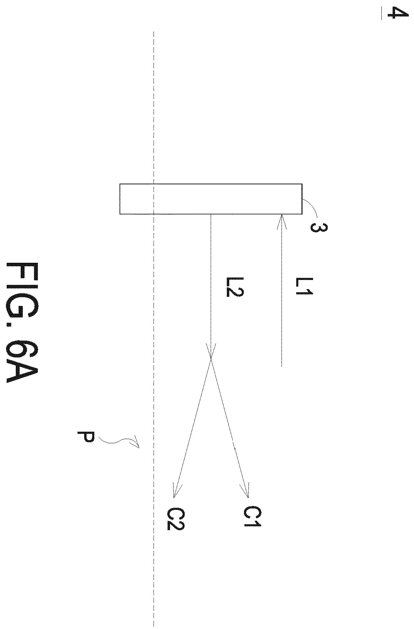

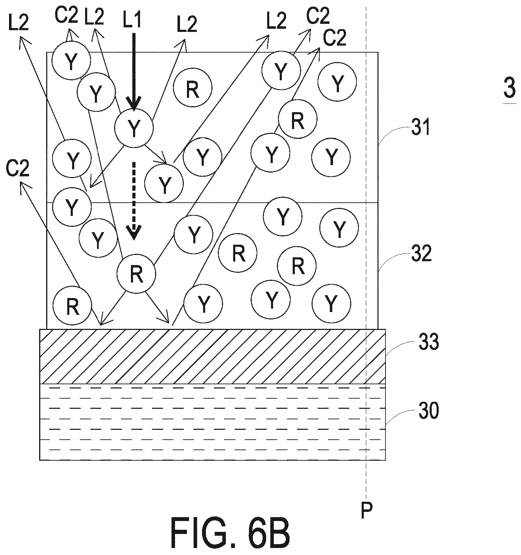

FIG. 6A schematically illustrates a phosphor device including a reflective substrate and an illumination system including the phosphor device according to an embodiment of the present invention. FIG. 6B schematically illustrates the structure of the phosphor device as shown in FIG. 6A. As shown in FIG. 6A and FIG. 6B, a phosphor device 3 including a reflective substrate of an illumination system 4 is disclosed herein. The illumination system 4 emits a first waveband light L1 along an optical path P. The phosphor device 3 includes a substrate 30, a first phosphor layer 31 and a second phosphor layer 32. The substrate 30 is disposed on the optical path P. The first phosphor layer 31 is formed on a side of the substrate 30. The second phosphor layer 32 is formed behind the first phosphor layer 31 along the optical path P. The first phosphor layer 31 includes a first phosphor agent Y and x weight percent (i.e. x wt%) of a second phosphor agent R. The second phosphor layer 32 includes the first phosphor agent Y and y weight percent (i.e. y wt%) of the second phosphor agent R, and y is greater than x (y>x). The first waveband light L1 is converted into a second waveband light L2 by the first phosphor agent Y. The second waveband light L2 includes a first color light C1 and a second color light C2. The first waveband light L1 is converted into the second color light C2 by the second phosphor agent R, thereby increasing the luminous intensity of the second color light C2.

Particularly, x is greater than 0, and y is less than 85. The relationship between x and y is given by 0<x<y<85. That is, the first phosphor layer 31 and the second phosphor layer 32 each includes a specific weight percent of the second phosphor agent R for converting the first waveband light L1 into the second color light C2 in range of 0-85, and the weight concentration of the second phosphor agent R of the second phosphor layer 32 is greater than the weight concentration of the second phosphor agent R of the first phosphor layer 31. In this embodiment, the first phosphor layer 31 is disposed for mainly decreasing the energy of the first waveband light.

The thickness of each of the first phosphor layer 31 and the second phosphor layer 32 is greater than or equal to 10 micrometers, and less than or equal to 500 micrometers. In preferred embodiments, the thickness of each of the first phosphor layer 31 and the second phosphor layer 32 is greater than or equal to 50 micrometers, and less than or equal to 200 micrometers.

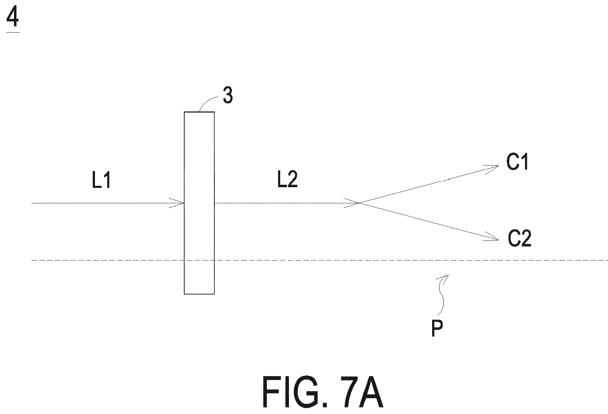

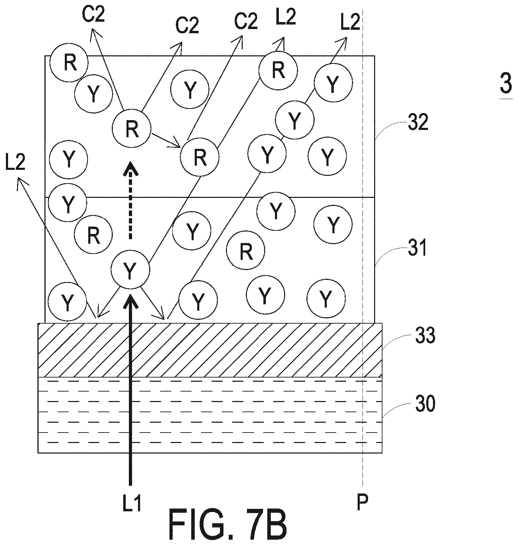

FIG. 7A schematically illustrates a phosphor device including a transmissive substrate and an illumination system including the phosphor device according to an embodiment of the present invention. FIG. 7B schematically illustrates the structure of the phosphor device as shown in FIG. 7A. As shown in FIG. 7A and FIG. 7B, a phosphor device 3 including a transmissive substrate of an illumination system 4 is disclosed herein. The illumination system 4 emits a first waveband light L1 along an optical path P. The phosphor device 3 includes a substrate 30, a first phosphor layer 31 and a second phosphor layer 32. The substrate 30, the first phosphor layer 31 and the second phosphor layer 32 are similar with the above-mentioned embodiment shown in FIGs. 6A and 6B, and are not redundantly described herein. The only difference between this embodiment and the embodiment shown in FIGs. 6A and 6B is that the substrate 30 shown in FIG. 6B is a reflective substrate, and the substrate 30 shown in FIG. 7B is a transmissive substrate.

Table II illustrates a comparison data. The intensity of red light of the phosphor device utilizing a red phosphor agent of prior art is assumed as 100% for being the base of the comparison.

**Table II**

| L1 Power (Watts) | Intensity of red light (Y) | Intensity of red light (R) | Intensity of red light (Y on Y+25wt%R) | Intensity of red light (Y+3.3wt%R on Y+25wt%R) |
|---|---|---|---|---|
| 25 | 84.9% | 100.0% | 102.1% | 109.8% |
| 76 | 119.0% | 100.0% | 138.5% | 138.8% |
| 102 | 134.0% | 100.0% | 154.3% | 151.2% |
| 152 | 162.7% | 100.0% | 182.5% | 173.6% |

From the above descriptions, the present invention provides a phosphor device and a manufacturing method thereof. By utilizing a phosphor layer including a first phosphor agent and a second phosphor agent, the luminous intensity of a color light, which is included in a second waveband light converted by the first phosphor agent, can be increased through the conversion of the second phosphor agent. Meanwhile, since a second phosphor layer including a first phosphor agent and a second phosphor agent is formed behind a first phosphor layer includes only the first phosphor agent along an optical path, most of the energy of a first waveband light is decreased by the first phosphor agent of the first phosphor layer, such that the conversion efficiency of the second phosphor agent is enhanced.

In summary there is disclosed a phosphor device 1, 3 of an illumination system 2, 4 which emits a first waveband light L1, including a substrate 10, 30 and a first phosphor layer 11, 31. The first phosphor layer 11, 31 includes a first phosphor agent Y and a second phosphor agent R. The first phosphor agent Y is formed on the substrate 10, 30 for converting the first waveband light L1 into a second waveband light L2. The second waveband light L2 comprises a first color light C1 and a second color light C2. The second phosphor agent R is distributed over the first phosphor agent Y for converting the first waveband light L1 into the second color light C2 so as to increase the luminous intensity of the second color light C2. Therefore, the luminous intensity of the second color light C2 can be effectively increased.

While the invention has been described in terms of what is presently considered to be the most practical and preferred embodiments, it is to be understood that the invention needs not be limited to the disclosed embodiment. The present invention is defined by the appended claims.

## Claims

1. A phosphor device (1, 3) of an illumination system (2, 4), the illumination system (2, 4) emitting a first waveband light (L1) to the phosphor device (1, 3) so as to be converted into a second waveband light (L2), the phosphor device (1, 3) comprising:
a substrate (10, 30);
a phosphor layer, comprising a first phosphor layer (12) and a second phosphor layer (11) formed on the substrate (10, 30), and
a reflective coating (13, 33) disposed between the substrate (10, 30) and the first phosphor layer (12) for reflecting at least the second waveband light (L2),
wherein the first phosphor layer (12) comprises:
a first phosphor agent (Y), wherein the first waveband light (L1) is converted into a waveband light comprising a first color light (C1) and a second color light (C2) by the first phosphor agent (Y); and
**characterized in that** the second phosphor layer (11) further comprises:
a second phosphor agent (R) distributed over the first phosphor agent (Y) of the phosphor layer (12) for converting the first waveband light (L1) into a third light, wherein the range of the spectrum of the second color light (C2) and the range of the spectrum of the third light are at least partially overlapped so as to increase the intensity of the second color light (C2), and the first color light (C1), the second color light (C2) and the third color light are integrated as the second waveband light (L2),
wherein the second phosphor agent (R) is mixed with the first phosphor agent (Y) as a mixture, and wherein the weight percentage of the second phosphor agent (R) is less than 85% relative to the first phosphor agent (Y).

2. The phosphor device (1, 3) according to claim 1, wherein the first phosphor agent (Y) is a yellow phosphor agent, and the second phosphor agent (R) is a red phosphor agent.

3. The phosphor device (1, 3) according to claim 2, wherein the reflective coating (13, 33) includes an all reflective coating or a dichroic coating.

4. The phosphor device (1, 3) according to claim 3, wherein while utilizing a dichroic coating as the reflective coating (13, 33), a light having the similar range of wavelength with the second waveband light (L2) is reflected by the reflective coating (13, 33).

5. The phosphor device (1, 3) according to claim 3, wherein while utilizing an all reflective coating as the reflective coating (13, 33), all of visible light is reflected by the reflective coating (13, 33).

6. The phosphor device (1, 3) according to claim 3, wherein the reflective coating (13, 33) is be pre-coated on the substrate (10, 30), or the reflective coating (13, 33) is formed on the substrate (10, 30) while processing.

7. The phosphor device (1, 3) according to claim 1, wherein the range of the spectrum of the third light converted by the second phosphor agent (R) can be selected or adjusted.

## Patentansprüche

1. Phosporvorrichtung (1, 3) eines Beleuchtungssystems (2, 4), wobei das Beleuchtungssystem (2, 4) Licht eines ersten Wellenlängenbereichs (L1) auf die Phosporvorrichtung (1, 3) aussendet, damit dieses in Licht eines zweiten Wellenlängenbereichs (L2) umgewandelt wird, wobei die Phosporvorrichtung (1, 3) umfasst:
ein Substrat (10, 30);
eine Phosporschicht, die eine erste Phosporschicht (12) und eine zweite Phosporschicht (11) umfasst, die auf dem Substrat (10, 30) ausgebildet sind, und
eine reflektierende Beschichtung (13, 33), die zwischen dem Substrat (10, 30) und der ersten Phosporschicht (12) angeordnet ist, um zumindest das Licht des zweiten Wellenbereichs (L2) zu reflektieren,
wobei die erste Phosporschicht (12) umfasst:
ein erstes Phospormittel (Y), wobei das Licht des ersten Wellenbereichs (L1) durch das erste Phospormittel (Y) in Licht eines Wellenbereichs umgewandelt wird, das ein Licht einer ersten Farbe (C1) und ein Licht einer zweiten Farbe (C2) umfasst; und
**dadurch gekennzeichnet, dass** die zweite Phosporschicht (11) ferner umfasst:
einen zweiten Phospor (R), der über dem ersten Phospor (Y) der Phosporschicht (12) verteilt ist, um das Licht des ersten Wellenbereichs (L1) in ein drittes Licht umzuwandeln, wobei sich der Spektralbereich des zweiten Farblichts (C2) und der Spektralbereich des dritten Lichts zumindest teilweise überlappen, um die Intensität des zweiten Farblichts (C2) zu erhöhen, und das Licht der ersten Farbe (C1), das Licht der zweiten Farbe (C2) und das Licht der dritten Farbe als Licht des zweiten Wellenlängenbereichs (L2) integriert sind,
wobei der zweite Phospor (R) mit dem ersten Phospor (Y) zu einer Mischung vermischt ist und wobei der Gewichtsanteil des zweiten Phospors (R) im Verhältnis zum ersten Phospor (Y) weniger als 85 % beträgt.

2. Phosporvorrichtung (1, 3) nach Anspruch 1, wobei das erste Phospormittel (Y) ein gelbes Phospormittel ist und das zweite Phospormittel (R) ein rotes Phospormittel ist.

3. Phosporvorrichtung (1, 3) nach Anspruch 2, wobei die reflektierende Beschichtung (13, 33) eine vollreflektierende Beschichtung oder eine dichroitische Beschichtung umfasst.

4. Phosporvorrichtung (1, 3) nach Anspruch 3, wobei bei Verwendung einer dichroitischen Beschichtung als reflektierende Beschichtung (13, 33) Licht mit einem ähnlichen Wellenlängenbereich wie das Licht des zweiten Wellenbandes (L2) von der reflektierenden Beschichtung (13, 33) reflektiert wird.

5. Phosporvorrichtung (1, 3) nach Anspruch 3, wobei bei Verwendung einer vollreflektierenden Beschichtung als reflektierende Beschichtung (13, 33) das gesamte sichtbare Licht von der reflektierenden Beschichtung (13, 33) reflektiert wird.

6. Phosporvorrichtung (1, 3) nach Anspruch 3, wobei die reflektierende Beschichtung (13, 33) auf das Substrat (10, 30) vorbeschichtet ist oder die reflektierende Beschichtung (13, 33) während der Verarbeitung auf dem Substrat (10, 30) gebildet wird.

7. Phosporvorrichtung (1, 3) nach Anspruch 1, wobei der Spektralbereich des durch das zweite Phospormittel (R) umgewandelten dritten Lichts ausgewählt oder eingestellt werden kann.

## Revendications

1. Dispositif à phosphore (1, 3) d'un système d'éclairage (2, 4), le système d'éclairage (2, 4) émet de la lumière d'une première gamme de longueurs d'onde (L1) sur le dispositif à phosphore (1, 3) afin que celle-ci soit convertie en lumière d'une deuxième gamme de longueurs d'onde (L2), le dispositif à phosphore (1, 3) comprenant :
un substrat (10, 30) ;
une couche de phosphore comprenant une première couche de phosphore (12) et une deuxième couche de phosphore (11) formées sur le substrat (10, 30), et
un revêtement réfléchissant (13, 33) disposé entre le substrat (10, 30) et la première couche de phosphore (12) afin de réfléchir au moins la lumière de la deuxième gamme de longueurs d'onde (L2),
la première couche de phosphore (12) comprenant :
un premier agent phosphorescent (Y), la lumière de la première gamme d'ondes (L1) étant convertie par le premier agent phosphorescent (Y) en lumière d'une gamme d'ondes comprenant une lumière d'une première couleur (C1) et une lumière d'une deuxième couleur (C2) ; et
**caractérisé en ce que** la deuxième couche de phosphore (11) comprend en outre :
un deuxième phosphore (R) réparti sur le premier phosphore (Y) de la couche de phosphore (12) afin de convertir la lumière de la première gamme d'ondes (L1) en une troisième lumière, la gamme spectrale de la deuxième lumière colorée (C2) et la gamme spectrale de la troisième lumière se chevauchant au moins partiellement afin d'augmenter l'intensité de la deuxième lumière colorée (C2), et la lumière de la première couleur (C1), la lumière de la deuxième couleur (C2) et la lumière de la troisième couleur sont intégrées en tant que lumière de la deuxième gamme de longueurs d'onde (L2),
le deuxième phosphore (R) étant mélangé au premier phosphore (Y) pour former un mélange, et la proportion en poids du deuxième phosphore (R) par rapport au premier phosphore (Y) étant inférieure à 85 %.

2. Dispositif à phosphore (1, 3) selon la revendication 1, dans lequel le premier moyen phosphorescent (Y) est un moyen phosphorescent jaune et le deuxième moyen phosphorescent (R) est un moyen phosphorescent rouge.

3. Dispositif à phosphore (1, 3) selon la revendication 2, dans lequel le revêtement réfléchissant (13, 33) comprend un revêtement totalement réfléchissant ou un revêtement dichroïque.

4. Dispositif à phosphore (1, 3) selon la revendication 3, dans lequel, lorsqu'un revêtement dichroïque est utilisé comme revêtement réfléchissant (13, 33), la lumière ayant une gamme de longueurs d'onde similaire à celle de la lumière de la deuxième bande d'ondes (L2) est réfléchie par le revêtement réfléchissant (13, 33).

5. Dispositif à phosphore (1, 3) selon la revendication 3, dans lequel, lorsqu'un revêtement entièrement réfléchissant est utilisé comme revêtement réfléchissant (13, 33), toute la lumière visible est réfléchie par le revêtement réfléchissant (13, 33).

6. Dispositif à phosphore (1, 3) selon la revendication 3, dans lequel le revêtement réfléchissant (13, 33) est pré-appliqué sur le substrat (10, 30) ou le revêtement réfléchissant (13, 33) est formé sur le substrat (10, 30) pendant le traitement.

7. Dispositif à phosphore (1, 3) selon la revendication 1, dans lequel la gamme spectrale de la troisième lumière convertie par le deuxième agent phosphorescent (R) peut être sélectionnée ou réglée.
